# EUROPEAN PATENT APPLICATION

(11) **EP 3 179 345 A1**
(43) Date of publication of application: **14.06.2017**
(21) Application number: 16179756.8
(22) Date of filing: 15.07.2016
(51) Int. Cl.: G06F 3/041

(54) **TRANSPARENT ELECTRODE PANEL AND MANUFACTURING METHOD THEREOF**

(30) Priority: 08.12.2015 KR 20150174169
(71) Applicant: Hyundai Motor Company, Seoul 06797 (KR)
(72) Inventor: KWEON, Kyoung Chun, 00000 Seoul (KR)
(74) Representative: Isarpatent

(57) **Abstract**

A transparent electrode panel may include a first substrate, and a plurality of first transparent electrodes positioned on the first substrate and including first and second electrodes, wherein the first electrode is positioned on the first substrate and is made of silver or copper, and the second electrode is positioned on the first electrode and is made of an indium tin oxide or a fluorine-doped tin oxide.

## Description

### BACKGROUND

### Field of the Invention

The present invention relates to a transparent electrode panel and a manufacturing method thereof.

### Description of Related Art

Industries and technology fields using a touch sensor and a transparent heating body require an electrode material which is transparent and has high electrical conductivity. Particularly, as use of a capacitive type of touch sensors for displays increases, an electrode material having high transmittance and low sheet resistance has been continuously applied.

Generally, indium tin oxide (ITO) is used as an electrode material that has high transmittance and low sheet resistance, but ITO is not suitable for a recent trend toward larger screen displays for improved visibility.

Since Indium, which is a main material of ITO, is costly and a processing cost thereof is high, and mechanical properties thereof are poor, researches for minimizing the use of ITO are being carried out.

The above information disclosed in this Background section is only to enhance the understanding of the background of the invention and should not be taken as an acknowledgement or any form of suggestion that this information forms the prior art already known to a person skilled in the art.

### SUMMARY

Various aspects of the present invention are directed to providing electrical conductivity and durability of a transparent electrode in a transparent electrode panel.

A transparent electrode panel according to various aspects of the present invention may include a first substrate, and a plurality of first transparent electrodes positioned on the first substrate and including first and second electrodes, wherein the first electrode is positioned on the first substrate and is made of silver or copper, and the second electrode is positioned on the first electrode and is made of an indium tin oxide or a fluorine-doped tin oxide.

A thickness of the first electrode may be about 1 µm to about 10 µm.

A thickness of the second electrode may be about 0.02 µm to about 0.2 µm.

The first transparent electrodes adjacent to each other may be separated by about 25 µm to about 100 µm.

The transparent electrode panel according to various aspects of the present invention may further may further include a plurality of first dummy electrodes positioned on the first substrate, wherein one of the plurality of first dummy electrodes is positioned between two of the plurality of first transparent electrodes.

The plurality of first dummy electrodes may respectively include a third electrode positioned on the first substrate, and a fourth electrode positioned on the third electrode.

The third electrode may be made of the same material as the first electrode, and thicknesses of the first and third electrodes may be about 1 µm to about 10 µm.

The fourth electrode may be made of the same material as the second electrode, and a thickness of the second electrode may be about 0.02 µm to about 0.2 µm.

The first transparent electrode and the first dummy electrode adjacent to each other may be separated by about 25 µm to about 100 µm.

The transparent electrode panel according to various aspects of the present invention a second substrate attached to a bottom surface of the first substrate, and a plurality of second transparent electrodes and a plurality of second dummy electrodes that are positioned on one surface of the second substrate, wherein one of the plurality of second dummy electrodes is positioned between two of the plurality of second transparent electrodes.

The plurality of second transparent electrodes may respectively may include a fifth electrode positioned on one surface of the second substrate and a sixth electrode positioned on the fifth electrode, and the plurality of second dummy electrodes may respectively may include a seventh electrode positioned on one surface of the second substrate and an eighth electrode positioned on the seventh electrode.

The fifth and seventh electrodes may be made of silver or copper, and thicknesses of the fifth and seventh electrodes may be about 1 µm to 10 um.

The sixth and eighth electrodes may be made of an indium tin oxide or a fluorine-doped tin oxide, and thicknesses of the sixth and eighth electrodes may be about 0.02 µm to about 0.2 µm.

The second transparent electrode and the second dummy electrode adjacent to each other may be separated by about 25 µm to about 100 µm.

A manufacturing method of a transparent electrode panel according to various aspects of the present invention may include forming a first electrode layer made of silver or copper on a first substrate, forming a second electrode layer made of an indium tin oxide or a fluorine-doped tin oxide on the first electrode layer, and forming a plurality of first transparent electrodes and a plurality of first dummy electrodes by etching the first and second electrode layers using a laser.

A thickness of the first electrode layer may be about 1 µm to about 10 µm, and a thickness of the second electrode layer may be about 0.02 µm to about 0.2 µm.

One of the plurality of first dummy electrodes may be formed between two of the plurality of first transparent electrodes, and the first transparent electrode and the first dummy electrode adjacent to each other may be separated by about 25 µm to about 100 µm.

The manufacturing method of a transparent electrode panel according to various aspects of the present invention may further include sequentially forming the first and second electrode layers on one surface of the second substrate, forming a plurality of second transparent electrodes and a plurality of second dummy electrodes by etching the first and second electrode layers formed on the one surface of the second substrate using a laser, and attaching the other surface of the second substrate to a bottom surface of the first substrate.

One of the plurality of second dummy electrodes may be formed between two of the plurality of second transparent electrodes, and the second transparent electrode and the second dummy electrode adjacent to each other may be separated by about 25 µm to about 100 µm.

As described above, according to various aspects of the present invention, the transparent electrode may be formed to have a dual layer structure of a metal having excellent electrical conductivity, such as silver (Ag) or copper (Cu), and a transparent metal oxide, such as an indium tin oxide (ITO) or a fluorine-doped tin oxide (FTO), thereby improving electrical conductivity of the transparent electrode and durability against external influences.

In addition, a defective rate can be decreased by etching the transparent electrode layer using a laser, and a distance between the respective electrodes can be minutely adjusted.

The methods and apparatuses of the present invention may have other features and advantages which will be apparent from or are set forth in more detail in the accompanying drawings, which are incorporated herein, and the following Detailed Description, which together serve to explain certain principles of the present invention.

### BRIEF DESCRIPTION OF THE DRAWINGS

FIG. 1 illustrates an example of a cross-sectional view of a transparent electrode panel according to an exemplary embodiment of the present invention.
FIG. 2 illustrates an example of a cross-sectional view of a transparent electrode panel according to another exemplary embodiment of the present invention.
FIGS. 3 and 4 schematically illustrate a manufacturing method of the transparent electrode panel according to FIG. 2.

It should be understood that the appended drawings are not necessarily to scale, presenting a somewhat simplified representation of various features illustrative of the basic principles of the invention. The specific design features of the present invention as disclosed herein, including, for example, specific dimensions, orientations, locations, and shapes will be determined in part by the particular intended application and use environment.

In the figures, reference numbers refer to the same or equivalent parts of the present invention throughout the several figures of the drawing.

### DETAILED DESCRIPTION

Reference will now be made in detail to various embodiments of the present invention(s), examples of which are illustrated in the accompanying drawings and described below. While the invention(s) will be described in conjunction with exemplary embodiments, it will be understood that the present description is not intended to limit the invention(s) to those exemplary embodiments. On the contrary, the invention(s) is/are intended to cover not only the exemplary embodiments, but also various alternatives, modifications, equivalents and other embodiments, which may be included within the spirit and scope of the invention as defined by the appended claims.

The present invention will be described more fully hereinafter with reference to the accompanying drawings, in which exemplary embodiments of the invention are shown. As those skilled in the art would realize, the described embodiments may be modified in various different ways, all without departing from the spirit or scope of the present invention. On the contrary, exemplary embodiments introduced herein are provided to make disclosed contents thorough and complete and to sufficiently transfer the spirit of the present invention to those skilled in the art.

In the drawings, the thickness of layers and regions may be exaggerated for clarity. In addition, when a layer is described to be formed "on" another layer or substrate, this means that the layer may be formed directly on the other layer or substrate, or a third layer may be interposed between the layer and the other layer or the substrate.

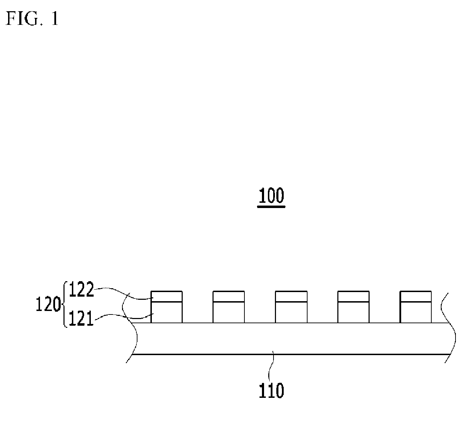

FIG. 1 illustrates an example of a cross-sectional view of a transparent electrode panel according to an exemplary embodiment of the present invention.

Referring to FIG. 1, the transparent electrode panel 100 according to the exemplary embodiment of the present invention includes a substrate 110, and a plurality of transparent electrodes 120 positioned on the substrate 110.

The substrate 110 may be an insulating substrate that is made of glass, quartz, ceramic, or plastic. Herein, when the substrate 110 is made of plastic, it may be made of any one of polyether imide (PEI), polycarbonate (PC), polyethylene naphthalate (PEN), polyimide (PI), polyarylate (PAR), and polyether sulfone (PES).

The plurality of transparent electrodes 120 are separated from each other on the substrate 110 by a predetermined distance. Herein, the predetermined distance should preferably be about 25 µm to about 100 µm.The plurality of transparent electrodes 120 respectively includes a first electrode 121, and a second electrode 122 positioned on the first electrode 121.

The first electrode 121 is positioned on the substrate 110, and maybe made of a metal having excellent electrical conductivity such as silver (Ag) or copper (Cu). A thickness of the first electrode 121 should preferably be about 1 µm to about 10 µm. Electrical conductivity of the transparent electrode 120 decreases when the thickness of the first electrode 121 is less than about 1 µm, and when the thickness of the first electrode 121 exceeds about 10 µm, transmittance of the transparent electrode 120 decreases, thereby decreasing visibility.

The second electrode 122 is provided to protect the first electrode 121 from external influences such as heat and oxygen, and may be made of a transparent metal oxide, such as an indium tin oxide (ITO) or a fluorine-doped tin oxide (FTO). A thickness of the second electrode 122 should preferably be about 0.02 µm to about 0.2 µm. When the thickness of the second electrode 122 is less than about 0.02 µm, electrical conductivity of the transparent electrode 120 decreases, and degradation and oxidation of the first electrode 121 cannot be prevented. When the thickness of the second electrode 122 exceeds about 0.2 µm, transmittance of the transparent electrode 120 decreases, thereby decreasing visibility.

As described above, the transparent electrode 120 may be formed to have a dual layer structure of a metal having excellent electrical conductivity, such as silver (Ag) or copper (Cu), and a transparent metal oxide, such as an indium tin oxide (ITO) or a fluorine-doped tin oxide (FTO), thereby improving electrical conductivity of the transparent electrode 120 as well as durability against external influences.

On the other hand, the transparent electrode panel 100 according to the exemplary embodiment of the present invention may be used for a heating coil or a touch switch.

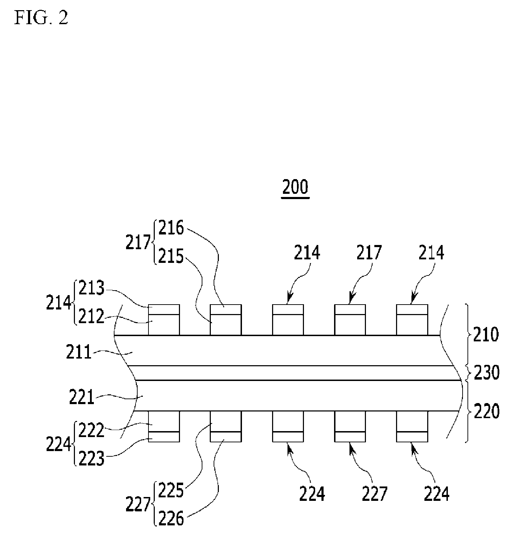

FIG. 2 illustrates an example of a cross-sectional view of a transparent electrode panel according to another exemplary embodiment of the present invention.

Referring to FIG. 2, the transparent electrode panel 200 according to the exemplary embodiment of the present invention includes an upper substrate 210, a lower substrate 220, and an adhesive 230 for adhering the upper substrate 210 to the lower substrate 220.

The upper substrate 210 includes a first substrate 211, and a plurality of first transparent electrodes 214 and a plurality of first dummy electrodes 217 that are positioned on the first substrate 211.

The first substrate 211 may be an insulating substrate that is made of glass, quartz, ceramic, or plastic. Herein, when the first substrate 211 is made of plastic, it may be made of any one of polyether imide (PEI), polycarbonate (PC), polyethylene naphthalate (PEN), polyimide (PI), polyarylate (PAR), and polyether sulfone (PES).

The plurality of first transparent electrodes 214 are separated from each other on the first substrate 211, and one first dummy electrode 217 is positioned between two first transparent electrodes 214. Herein, a distance between the first transparent electrode 214 and the first dummy electrode 217 adjacent to each other should preferably be about 25 µm to about 100 µm.

The plurality of first transparent electrodes 214 respectively include a first electrode 212, and a second electrode 213 positioned on the first electrode 212.

The first electrode 212 is positioned on the first substrate 211, and maybe made of a metal having excellent electrical conductivity such as silver (Ag) or copper (Cu). A thickness of the first electrode 212 should preferably be about 1 µm to about 10 µm. Electrical conductivity of the first transparent electrode 214 decreases when the thickness of the first electrode 212 is less than about 1 µm, and when the thickness of the first electrode 212 exceeds 10 µm, transmittance of the first transparent electrode 214 decreases, thereby decreasing visibility.

The second electrode 213 is provided to protect the first electrode 212 from external influences such as heat and oxygen, and may be made of a transparent metal oxide, such as an indium tin oxide (ITO) or a fluorine-doped tin oxide (FTO). A thickness of the second electrode 213 should preferably be about 0.02 µm to about 0.2 µm. When the thickness of the second electrode 213 is less than about 0.02 µm, electrical conductivity of the first transparent electrode 214 decreases, and degradation and oxidation of the first electrode 212 cannot be prevented. When the thickness of the second electrode 213 exceeds about 0.2 µm, transmittance of the first transparent electrode 214 decreases, thereby decreasing visibility.

The plurality of first dummy electrodes 217 respectively include a third electrode 215, and a fourth electrode 216 positioned on the third electrode 215.

The third electrode 215 is positioned on the first substrate 211, and the material and thickness of the third electrode 215 are the same as the material and thickness of the first electrode 212, respectively. The third electrode 215 is positioned on the first substrate 211, and the material and thickness of the third electrode 215 are the same as the material and thickness of the first electrode 212, respectively.

The lower substrate 220 is attached to a bottom surface of the upper substrate 210 by the adhesive 230, and includes a second substrate 221, and a plurality of second transparent electrodes 224 and a plurality of second dummy electrodes 227 that are positioned on one surface of the second substrate 221. The other surface of the second substrate 221 is adhered to a bottom surface of the first substrate 211.

The second substrate 221 may be an insulating substrate that is made of glass, quartz, ceramic, or plastic. Herein, when the second substrate 221 is made of plastic, it may be made of any one of polyether imide (PEI), polycarbonate (PC), polyethylene naphthalate (PEN), polyimide (PI), polyarylate (PAR), and polyether sulfone (PES).

The plurality of second transparent electrodes 224 are separated from each other on one surface of the second substrate 221, and one second dummy electrode 227 is positioned between two second transparent electrodes 224. Herein, a distance between the second transparent electrode 224 and the second dummy electrode 227 adjacent to each other should preferably be about 25 µm to about 100 µm.

The plurality of second transparent electrodes 224 respectively include a fifth electrode 222, and a sixth electrode 223 positioned on one surface of the fifth electrode 222.

The fifth electrode 222 is positioned on one surface of the second substrate 221, and may be made of a metal having excellent electrical conductivity such as silver (Ag) or copper (Cu). A thickness of the fifth electrode 222 should preferably be about 1 µm to about 10 µm. Electrical conductivity of the second transparent electrode 224 decreases when the thickness of the fifth electrode 222 is less than about 1 µm, and when the thickness of the fifth electrode 222 exceeds about 10 µm, transmittance of the second transparent electrode 224 decreases, thereby decreasing visibility.

The sixth electrode 223 is provided to protect the fifth electrode 222 from external influences such as heat and oxygen, and may be made of a transparent metal oxide such as an indium tin oxide (ITO) or a fluorine-doped tin oxide (FTO). A thickness of the sixth electrode 223 should preferably be about 0.02 µm to about 0.2 µm. When the thickness of the sixth electrode 223 is less than about 0.02 µm, electrical conductivity of the second transparent electrode 224 decreases, and degradation and oxidation of the fifth electrode 222 cannot be prevented. When the thickness of the sixth electrode 223 exceeds about 0.2 µm, transmittance of the second transparent electrode 224 decreases, thereby decreasing visibility.

The plurality of second dummy electrodes 227 respectively include a seventh electrode 225, and an eighth electrode 226 positioned on one surface of the seventh electrode 225.

The seventh electrode 225 is positioned on one surface of the second substrate 221, and the material and thickness of the seventh electrode 225 are the same as the material and thickness of the fifth electrode 222, respectively. In addition, the material and thickness of the eighth electrode 226 are the same as the material and thickness of the sixth electrode 223, respectively.

The transparent electrode panel 200 according to the exemplary embodiment of the present invention may be used as a touch panel. In this case, the upper substrate 210 may be a transmitter, while the lower substrate 220 may be a receiver. In addition, while not limited thereto, the upper substrate 210 may be a receiver, and the lower substrate 220 may be a transmitter.

The first dummy electrode 217 positioned on the upper substrate 210 and the second dummy electrode 227 positioned on the lower substrate 220 respectively serve to reduce the effect of the first and second transparent electrodes 214 and 224 being seen by a consumer's eyes, depending on refractive index differences between the first and second substrates 211 and 221 and the first and second transparent electrodes 214 and 224. Accordingly, the first dummy electrode 217 and the second dummy electrode 227 may improve visibility of the first transparent electrode 214 and visibility of the second transparent electrode 224, respectively.

In another exemplary embodiment of the present invention, the first and second dummy electrodes 217 and 227 may be aligned symmetric with respect to the first and second substrates 211 and 221.

In further another exemplary embodiment of the present invention, the first and second transparent electrodes 214 and 224 may be aligned symmetric with respect to the first and second substrates 211 and 221.

Referring to Table 1, characteristics of a touch panel according to the exemplary embodiment of the present invention will now be described.

In Table 1, performances of the touch panel according to the exemplary embodiment of the present invention and a touch panel according to a comparative example are evaluated.

A transparent electrode of the touch panel according to the exemplary embodiment of the present invention is formed to have a dual layer structure of Ag / FTO, and a transparent electrode of the touch panel of the comparative example is formed to have a single layer structure of ITO.

It can be seen that both the touch panel according to the exemplary embodiment of the present invention and the touch panel of the comparative example are in a normal operating state at a high temperature.

**[Table 1]**

| | Comparative example | | | | Exemplary embodiment | | | |
|---|---|---|---|---|---|---|---|---|
| Electrode structure | ITO (single layer) | | | | Ag / FTO (dual layer) | | | |
| Evaluation item | Initial state | Hot | Hot and humid | Therma 1 shock | Initial state | Hot | Hot and humid | Thermal shock |
| Operating state | Normal | Normal | Malfunc tion | Malfun ction | Normal | Normal | Normal | Normal |
| Surface resistance (Ω) | 150 | | | | 50 | | | |
| Transmittance (%) | 89.3 | 87.0 | 86.38 | 87.8 | 89 | 88.5 | 87.9 | 88.6 |

In a hot and humid (85 °C, 85%) state, it can be seen that the touch panel according to the exemplary embodiment of the present invention is in a normal operating state after 240 hrs., while the touch panel of the comparative example malfunctions.

Under a thermal shock (-40 °C ~ 95°C) state, the touch panel according to the exemplary embodiment of the present invention is in a normal operating state after 168 hrs. while the touch panel of the comparative example malfunctions.

That is, it can be seen that reliability of the touch panel according to the exemplary embodiment of the present invention is improved under the hot and humid conditions and thermal shock conditions.

In addition, under the hot and humid conditions and thermal shock conditions, the touch panel according to comparative example shows transmittance reduced by a maximum of 3 %, and the touch panel according to the exemplary embodiment of the present invention shows transmittance reduced by a maximum of 1 %. That is, it can be seen that the decrease in transmittance of the touch panel according to the exemplary embodiment of the present invention is negligible under the hot and humid conditions and thermal shock conditions.

In addition, it can be seen that the touch panel according to the exemplary embodiment of the present invention has lower sheet resistance than the touch panel according to comparative example.

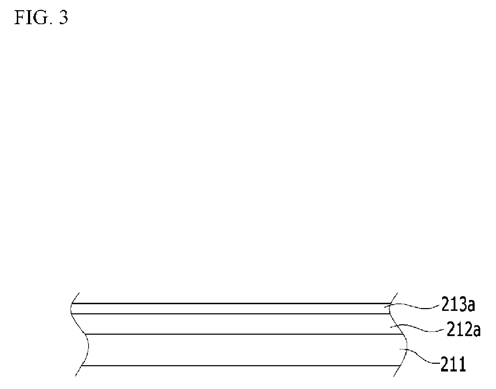

A manufacturing method of the transparent electrode panel of FIG. 2 will be now described with reference to FIGS. 3, 4, and 2.

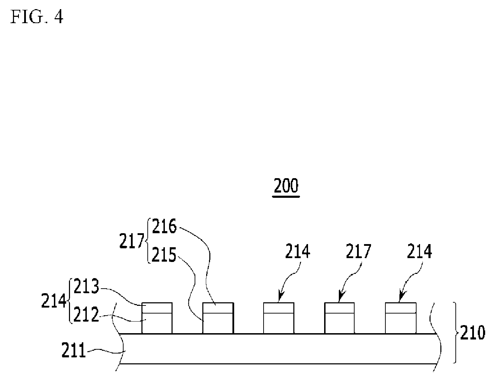

FIGS. 3 and 4 schematically illustrate a manufacturing method of the transparent electrode panel of FIG. 2.

Referring to FIG. 3, a first metal layer 212a and a second metal layer 213a are sequentially formed on a first substrate 211.

The first metal layer 212a is formed of a metal having excellent electrical conductivity such as silver (Ag) or copper (Cu), and a thickness thereof should preferably be about 1 µm to about 10 µm. The second metal layer 213a is formed of a transparent metal oxide such as an indium tin oxide (ITO) or a fluorine-doped tin oxide (FTO), and a thickness thereof should preferably be about 0.02 µm to about 0.2 µm.

Referring to FIG. 4, a plurality of first transparent electrodes 214 and a plurality of first dummy electrodes 217 are formed by etching the first metal layer 212a and the second metal layer 213a. As a result, the upper substrate 210 is completed.

Herein, the first transparent electrodes 214 and the first dummy electrodes 217 are alternately formed on the first substrate 211 one by one. That is, one first dummy electrode 217 is formed between two first transparent electrodes 214.

In this case, a laser is used to etch the first metal layer 212a and the second metal layer 213a. Since the first metal layer 212a and the second metal layer 213a are etched using a laser, a defective rate may decrease and a distance between the respective electrodes may be minutely adjusted. Herein, a distance between the first transparent electrode 214 and the first dummy electrode 217 adjacent to each other should preferably be about 25 µm to about 100 µm.

Referring to FIG. 2, after a lower substrate 220 is formed as in the manufacturing process of the upper substrate 210, an upper substrate 210 and the lower substrate 220 are attached using an adhesive 230.

That is, in the lower substrate 220, after sequentially forming the first and second metal layers 212a and 213a at one surface of the second substrate 221, the first and second metal layers 212a and 213a are etched using a laser to form a plurality of second transparent electrodes 224 and a plurality of second dummy electrodes 227. Herein, the second transparent electrodes 224 and the second dummy electrodes 227 are alternately formed one by one on the second substrate 221. That is, one second dummy electrode 227 is formed between two second transparent electrodes 224.

On the other hand, in a manufacturing method of the transparent electrode panel of FIG. 1, similar to FIGS. 3 and 4, a first metal layer 212a and a second metal layer 213a are sequentially formed on a substrate 110, the first and second metal layers 212a and 213a are etched using a laser to form a plurality of transparent electrodes 120.

For convenience in explanation and accurate definition in the appended claims, the terms "upper", "lower", "inner", "outer", "up", "down", "upper", "lower", "upwards", "downwards", "front", "rear", "back", "inside", "outside", "inwardly", "outwardly", "interior", "exterior", "inner", "outer", "forwards", and "backwards" are used to describe features of the exemplary embodiments with reference to the positions of such features as displayed in the figures.

The foregoing descriptions of specific exemplary embodiments of the present invention have been presented for purposes of illustration and description. They are not intended to be exhaustive or to limit the invention to the precise forms disclosed, and obviously many modifications and variations are possible in light of the above teachings. The exemplary embodiments were chosen and described in order to explain certain principles of the invention and their practical application, to thereby enable others skilled in the art to make and utilize various exemplary embodiments of the present invention, as well as various alternatives and modifications thereof. It is intended that the scope of the invention be defined by the Claims appended hereto and their equivalents.

## Claims

1. A transparent electrode panel comprising:
a first substrate; and
a plurality of first transparent electrodes positioned on the first substrate and including first and second electrodes,
wherein the first electrode is positioned on the first substrate and is made of silver or copper, and
wherein the second electrode is positioned on the first electrode and is made of an indium tin oxide or a fluorine-doped tin oxide.

2. The transparent electrode panel of claim 1, wherein a thickness of the first electrode is about 1 µm to about 10 µm.

3. The transparent electrode panel of claim 2, wherein a thickness of the second electrode is about 0.02 µm to about 0.2 µm.

4. The transparent electrode panel of claim 3, wherein the first transparent electrodes adjacent to each other are separated by about 25 µm to about 100 µm.

5. The transparent electrode panel of claim 1, further comprising a plurality of first dummy electrodes positioned on the first substrate, wherein one of the plurality of first dummy electrodes is positioned between two adjacent first transparent electrodes of the plurality of first transparent electrodes.

6. The transparent electrode panel of claim 5, wherein the plurality of first dummy electrodes respectively include a third electrode positioned on the first substrate, and a fourth electrode positioned on the third electrode.

7. The transparent electrode panel of claim 6, wherein the third electrode is made of a same material as the first electrode, and thicknesses of the first and third electrodes are about 1 µm to about 10 µm.

8. The transparent electrode panel of claim 7, wherein the fourth electrode is made of a same material as the second electrode, and a thickness of the second electrode is about 0.02 µm to about 0.2 µm.

9. The transparent electrode panel of claim 8, wherein the first transparent electrode and the first dummy electrode adjacent to each other are separated by about 25 µm to about 100 µm.

10. The transparent electrode panel of claim 9, further comprising a second substrate attached to a bottom surface of the first substrate, and a plurality of second transparent electrodes and a plurality of second dummy electrodes that are positioned on a surface of the second substrate, wherein one of the plurality of second dummy electrodes is positioned between two adjacent second transparent electrodes of the plurality of second transparent electrodes.

11. The transparent electrode panel of claim 10, wherein the plurality of second transparent electrodes respectively include a fifth electrode positioned on a surface of the second substrate and a sixth electrode positioned on the fifth electrode, and the plurality of second dummy electrodes respectively include a seventh electrode positioned on a surface of the second substrate and an eighth electrode positioned on the seventh electrode.

12. The transparent electrode panel of claim 11, wherein the fifth and seventh electrodes are made of silver or copper, and thicknesses of the fifth and seventh electrodes are about 1 µm to about 10 µm.

13. The transparent electrode panel of claim 12, wherein the sixth and eighth electrodes are made of an indium tin oxide or a fluorine-doped tin oxide, and thicknesses of the sixth and eighth electrodes are about 0.02 µm to about 0.2 µm.

14. The transparent electrode panel of claim 13, wherein the second transparent electrode and the second dummy electrode adjacent to each other are separated by about 25 µm to about 100 µm.

15. The transparent electrode panel of claim 6, further comprising a second substrate attached to a bottom surface of the first substrate, and a plurality of second transparent electrodes and a plurality of second dummy electrodes that are positioned on a surface of the second substrate, wherein the first and second dummy electrodes are aligned symmetric with respect to the first and second substrates.

16. A manufacturing method of a transparent electrode panel comprising:
forming a first electrode layer made of silver or copper on a first substrate;
forming a second electrode layer made of an indium tin oxide or a fluorine-doped tin oxide on the first electrode layer; and
forming a plurality of first transparent electrodes and a plurality of first dummy electrodes by etching the first and second electrode layers using a laser.

17. The manufacturing method of claim 16, wherein a thickness of the first electrode layer is about 1 µm to about 10 µm, and a thickness of the second electrode layer is about 0.02 µm to about 0.2 µm.

18. The manufacturing method of claim 17, wherein one of the plurality of first dummy electrodes is formed between two of the plurality of first transparent electrodes, and the first transparent electrode and the first dummy electrode adjacent to each other are separated by about 25 µm to about 100 µm.

19. The manufacturing method of claim 18, further comprising sequentially forming the first and second electrode layers on a first surface of the second substrate, forming a plurality of second transparent electrodes and a plurality of second dummy electrodes by etching the first and second electrode layers formed on the first surface of the second substrate using a laser; and attaching a second surface of the second substrate to a bottom surface of the first substrate.

20. The manufacturing method of claim 19, wherein one of the plurality of second dummy electrodes is formed between two of the plurality of second transparent electrodes, and the second transparent electrode and the second dummy electrode adjacent to each other are separated by about 25 µm to about 100 µm.
